# EUROPEAN PATENT APPLICATION

(11) **EP 1 852 904 A1**
(43) Date of publication of application: **07.11.2007**
(21) Application number: 06712063.4
(22) Date of filing: 20.01.2006
(51) Int. Cl.: H01L 21/318, H01L 29/78

(54) **DIELECTRIC FILM AND METHOD FOR FORMING THE SAME**

(30) Priority: 01.02.2005 JP 2005025648; 06.09.2005 JP 2005257946
(71) Applicant: TOHOKU UNIVERSITY, Aoba-ku Sendai-shi, Miyagi 980-8577 (JP)
(72) Inventor: OHMI, Tadahiro, c/o TOHOKU UNIVERSITY, Sendai-shi, Miyagi, 980-8577 (JP); TERAMOTO, Akinobu, c/o TOHOKU UNIVERSITY, Sendai-shi, Miyagi, 980-8577 (JP); GOTO, Tetsuya, c/o TOHOKU UNIVERSTY, Sendai-shi, Miyagi, 980-8577 (JP); KAWASE, Kazumasa, c/o TOHOKU UNIVERSITY, Sendai-shi, Miyagi, 980-8577 (JP)
(74) Representative: Glawe, Delfs, Moll
(86) International application number: PCT/JP2006/300838
(87) International publication number: WO 2006/082718

(57) **Abstract**

A dielectric film wherein N in the state of an Si₃≡N bonding is present in a concentration of 3 atomic % or more in the surface side of an oxide film and also is present in a concentration of 0.1 atomic % or less in the interface side of the oxide film can achieve the prevention of the B diffusion and also the prevention of the deterioration of the NBTI resistance in combination. When the Ar/N₂ radical nitridation is used, it is difficult for the resultant oxide film to satisfy the condition wherein N in the above bonding state is present in a concentration of 3 atomic % or more in the surface side of an oxide film and simultaneously is present in a concentration of 0.1 atomic % or less in the interface side of the oxide film, whereas, the above distribution of the N concentration can be achieved by using any of the gas combinations of Xe/N₂, Kr/N₂, Ar/NH₃, Xe/NH₃, Kr/NH₃, Ar/N₂/H₂, Xe/N₂/H₂ and Kr/N₂/H₂.

## Description

### Technical Field

This invention relates to a dielectric film such as an oxide film, a nitride film, or an oxynitride film formed on a silicon substrate, a method of forming the dielectric film, a semiconductor device using them, and a method of manufacturing the semiconductor device.

### Background Art

A silicon oxide dielectric film (hereinafter referred to as a silicon oxide film) serving as a gate insulating film of a MOS (metal film electrode/silicon oxide dielectric film/silicon substrate) transistor is required to have various high insulating characteristics and high reliabilities such as a low leakage current characteristic, a low interface state density, a low threshold voltage shift, and a low threshold variation characteristic.

Further, B (boron)-doped polysilicon (poly-Si) is generally used as a metal film electrode of a p-type MOS transistor and this B diffuses into a silicon oxide dielectric film and reaches a silicon substrate forming a channel.

When B diffuses into the silicon oxide film or the channel, there arises a problem of causing a shift in threshold voltage or variation in threshold voltage.

The higher performance of semiconductor devices has been achieved by miniaturization of elements, but, following it, the thickness of a silicon oxide film should be minimized so that the diffusion of B cannot be ignored. In view of this, proposal is made of a method of nitriding a silicon oxide film to prevent diffusion of B (see Non-Patent Document 1 G. Lucovsky, D. R. Lee, S.V. Hattangady, H. Niimi, Z. Jing, C. Parker and J. R. Hauser, Jpn. J. Appl. Phys. 34 (1995) 6827).

In the method of carrying out nitriding at about 800°C using an NO or N₂O gas, a silicon oxide film is not nitrided but a silicon substrate is nitrided, and N is distributed at the silicon oxide film/silicon substrate interface (see Non-Patent Document 2 K. Kawase, J. Tanimura, H. Kurokawa, K. Kobayashi, A. Teramoto, T. Ogata and M. Inoue, Materials Science in Semiconductor Processing 2 (1999) 225).

In this method, although the diffusion of B into the silicon substrate can be prevented, the diffusion of B into the silicon oxide film cannot be avoided. Further N at the interface causes a problem of degradation of NBTI (threshold voltage shift upon negative bias application) characteristics (see Non-Patent Document 3 N. Kimizuka, K. Yamaguchi, K. Imai, T. lisuka, C. T. Liu, R. C. Keller and T. Horiuchi, Symp. VLSI Tech. 2000, p. 92). Accordingly, attention is paid to radical oxidation that can introduce N into a silicon oxide film only on the surface side thereof.

The radical oxidation is a method of irradiating a microwave to an N₂ gas diluted with an Ar gas to generate a plasma, thereby nitriding a silicon oxide film using highly reactive free radicals.

Since N is introduced only on the surface side, the silicon oxide film formed by this method has effects of preventing the diffusion of B into the silicon oxide film and suppressing the degradation of NBTI characteristics.

### Disclosure of the Invention

### Problem to be Solved by the Invention

However, following the miniaturization of elements, a silicon oxide film should be an ultrathin film having a thickness of 1.5nm or less. As a result, it is quite difficult to completely prevent N from being introduced to the silicon oxide film/silicon substrate interface. Thus, the degradation of NBTI characteristics is becoming a problem.

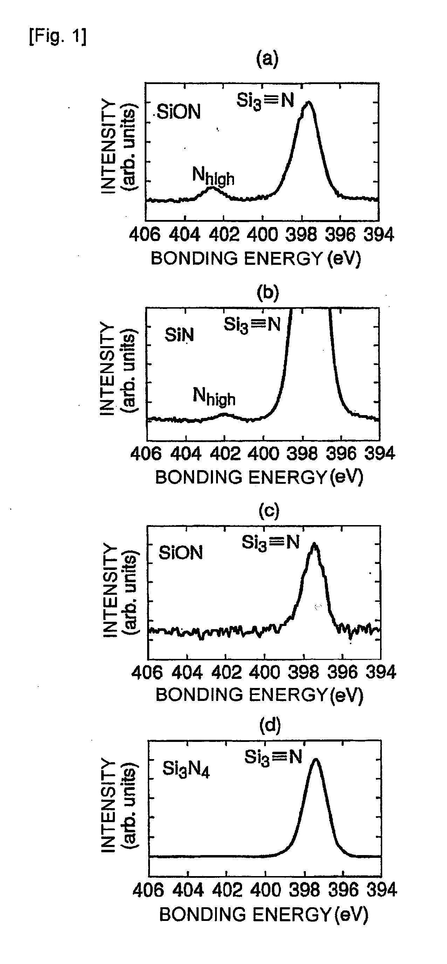

As shown in Fig. 1, (a), in the XPS N1s core-level spectrum of an Ar/N₂ radical oxynitride film, in addition to a peak indicating an Si₃≡N bonding (three bonds of N are all connected to Si), there is observed another peak about a bonding (hereinafter referred to as N_{high}) on the high bonding energy side. Since this peak is also detected in an SiN film formed by Ar/N₂ radical-nitriding a Si substrate (Fig. 1, (b)), it is understood that it is not a bonding with O but a bonding between Si and N, while it is an unstable bonding that cannot form Si₃≡N. Further, it is a bonding unique to radical nitriding, which is not observed at all in a conventional silicon oxide film thermally nitrided by an NO gas (Fig. 1, (c)) or in a conventional Si₃N₄ film formed by CVD (Fig. 1, (d)).

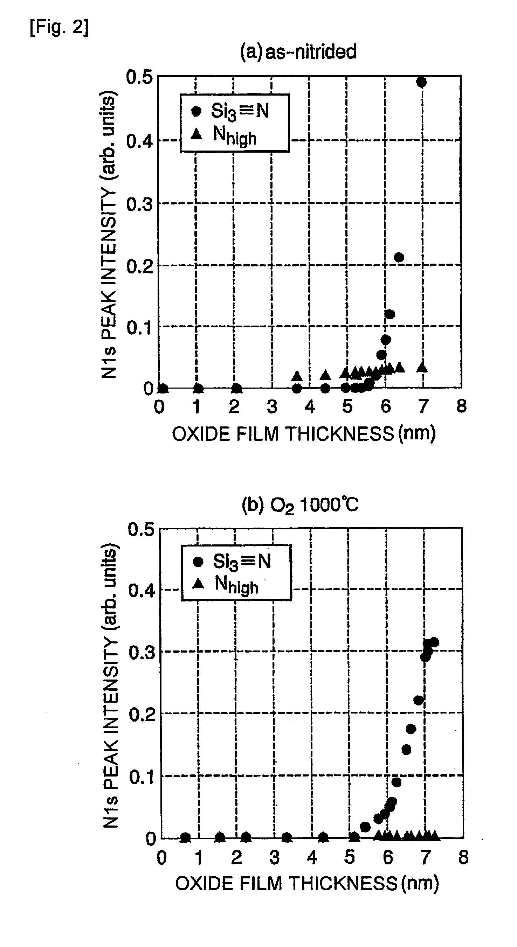

Depth distributions, in the silicon oxide film, of N in these two bonding states are as shown in Fig. 2, (a). Since the totally different distributions are exhibited, at least two kinds of nitriding species participate in the nitriding.

Generally, when a gate insulating film of a transistor is exposed to a plasma, electrons having high energy give a damage thereto. Therefore, recovery by O₂ post-annealing is required. However, if the O₂ post-annealing is performed, the distribution of Si₃≡N expands to the interface side as shown in Fig. 2, (b) or Fig. 3 which is an enlarged diagram of the skirt of the Si₃≡N distribution of Fig. 2. Thus, this is a cause of inducing the degradation of NBTI characteristics. This is because O₂ cuts Si-N bonds and part of free N move to the interface side.

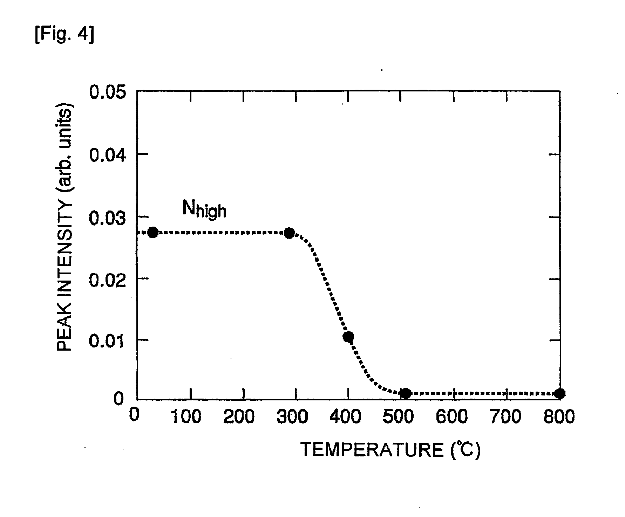

On the other hand, with respect to N_{high}, it is completely removed by the O₂ post-annealing as shown in Fig. 2, (b) or Fig. 3. Further, as shown in Fig. 4, it can be completely removed by annealing in a vacuum at 500°C or more.

Incidentally, the nitriding species adapted to form N_{high} enters deeper than the nitriding species adapted to form Si₃≡N and reaches the interface if the silicon oxide film as a base is reduced in thickness.

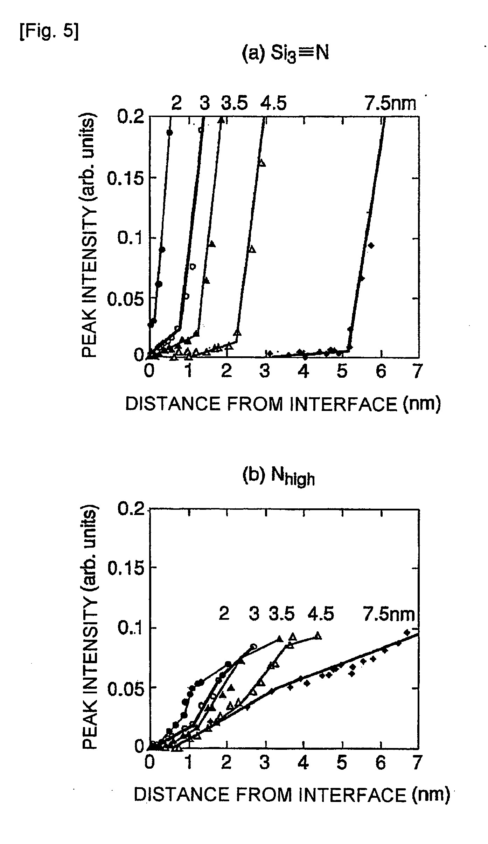

However, as clear from the base film thickness dependence of depth distribution shown in Fig. 5, (b), N_{high} cannot exist at the silicon oxide film/silicon substrate interface.

Conversely, as shown in Fig. 5, (a), when the base film thickness decreases, the skirt of the distribution tails so that Si₃≡N is susceptible to be introduced to the interface.

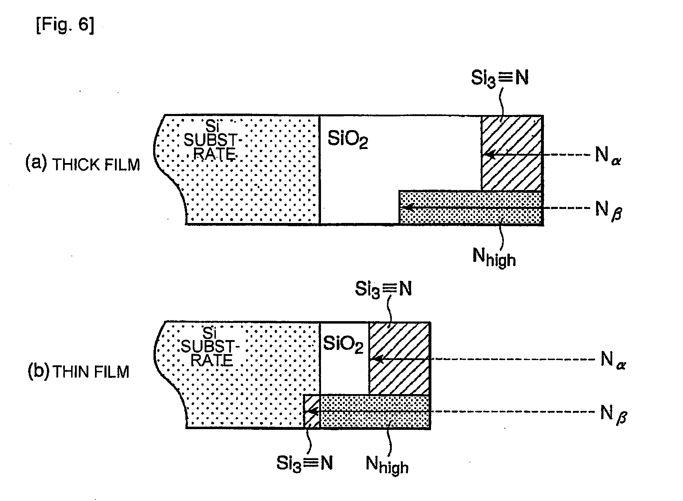

Specifically, it is understood that, as shown in Fig. 6, the nitriding species (hereinafter N_{β}) adapted to form N_{high} reaches the interface earlier than the nitriding species (hereinafter N_{α}) adapted to form Si₃≡N on the surface and forms Si₃≡N in the vicinity of the interface. This N in the vicinity of the interface causes the degradation of NBTI characteristics.

Even if N_{high} can be removed by the annealing, the presence of the nitriding species N_{β} adapted to form N_{high} is a problem.

When the film forming temperature is set to 500°C or more, although N_{high} is not present in the film, N_{β} is present and diffuses in the silicon oxide film. Therefore, the formation of Si₃≡N in the vicinity of the interface cannot be avoided.

Rather, when the film forming temperature is high, the diffusion of Nβ is facilitated and thus the amount of Si₃≡N formation in the vicinity of the interface increases.

Further, N_{high} cannot form stable Si₃≡N and thus is in an unstable bonding state, but after desorbed by the annealing, generates fixed charges due to silicon dangling bonds. Accordingly, this can be a cause of degrading the insulating properties, such as an increase in leakage current. Therefore, it is highly desirable to perform film formation under the conditions in which the nitriding species adapted to form N_{high} is not present in a plasma.

This invention has been made for solving the foregoing problems and has an object to provide a dielectric film and its forming method that can suppress generation, in a plasma, of a nitriding species adapted to form N_{high}, thereby preventing formation of N_{high} in the silicon oxide film and formation of Si₃≡N in the vicinity of the interface.

### Means for Solving the Problem

In order to achieve the aforementioned object, according to this invention, there is provided a dielectric film formed on a silicon surface, wherein: an N concentration at a surface of the dielectric film is 3 at% or more, an N concentration present at an interface between the silicon surface and the dielectric film is 0.1 at% or less, and a film thickness is 2nm or less.

Further, according to this invention, there is provided a semiconductor device comprising a silicon substrate, a dielectric film formed on a surface of the silicon substrate, and an electrode formed on the dielectric film, wherein: an N concentration at a surface of the dielectric film is 3 at% or more, an N concentration present at an interface between the silicon surface and the dielectric film is 0.1 at% or less, and a film thickness is 2nm or less.

Further, according to this invention, there is provided a method of forming a dielectric film, comprising the steps of: forming a silicon oxide film on a surface of a silicon substrate, and altering a surface of the silicon oxide film by exposing the surface to a nitriding species such as a nitriding radical species, a nitriding excited active species, or a nitriding ion species.

Further, according to this invention, there is provided a method of manufacturing the semiconductor device, comprising the steps of: forming a silicon oxide film on a surface of a silicon substrate, altering a surface of the silicon oxide film by exposing the surface to a nitriding species such as a nitriding radical species, a nitriding excited active species, or a nitriding ion species, and forming a gate electrode on the altered surface of the silicon oxide film.

Herein, the nitriding radical species is preferably at least one radical selected from the group consisting of N radical, N⁺ ion radical, N₂ radical, N₂+ ion radical, NH radical, and NH⁺ ion radical.

Further, the nitriding radical is formed by a microwave plasma formed in a mixed gas of Ar and NH₃, a mixed gas of Xe and N₂, a mixed gas of Xe and NH₃, a mixed gas of Kr and N₂, a mixed gas of Kr and NH₃, a mixed gas ofAr, N₂, and H₂, a mixed gas of Xe, N₂, and H₂, and a mixed gas of Kr, N₂, and H₂.

Further, the step of altering the surface of the silicon oxide film by exposing the surface to the nitriding species such as the nitriding radical species, the nitriding excited active species, or the nitriding ion species is preferably not followed by post-annealing at 600°C or more.

As described above, in this invention, in order to reduce the generation efficiency, in a plasma, of a nitriding species adapted to form N_{high}, an NH₃ gas is used instead of N₂. In this manner, radical nitriding using an Ar/NH₃ gas is carried out.

Alternatively, in order to reduce the generation efficiency, in a plasma, of a nitriding species adapted to form N_{high}, a Xe or Kr gas is used instead of Ar. In this manner, radical nitriding using a Xe/N₂ gas or a Kr/N₂ gas is carried out.

Alternatively, in order to reduce the generation efficiency, in a plasma, of a nitriding species adapted to form N_{high}, an NH₃ gas is used instead of N₂ and a Xe gas or a Kr gas is used instead of Ar. In this manner, radical nitriding using a Xe/NH₃ gas or a Kr/NH₃ gas is carried out.

Alternatively, in order to reduce the generation efficiency, in a plasma, of a nitriding species adapted to form N_{high}, H₂ is added to Ar/N₂, Xe/N₂, or Kr/N₂. In this manner, radical nitriding using an Ar/N₂/H₂, Xe/N₂/H₂, or Kr/N₂/H₂ gas is carried out.

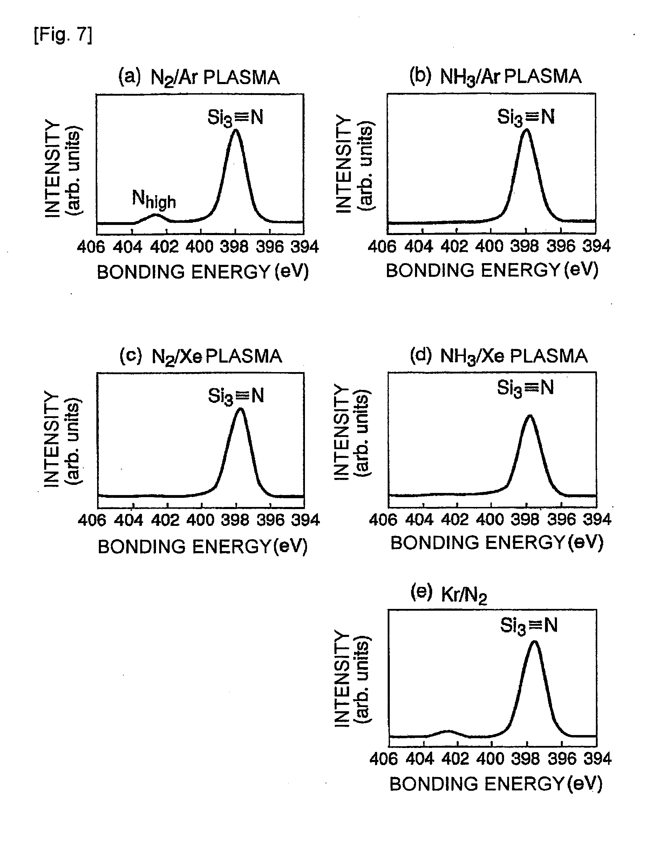

By these methods, the formation of N_{high} can be significantly reduced as shown in Fig. 7, (a) to (e). Herein, (a) is the case where an N₂/Ar plasma is used, (b) is the case where an NH₃/Ar plasma is used, (c) is the case where an N₂/Xe plasma is used, (d) is the case where an NH₃/Xe plasma is used, and (e) is the case where a Kr/N₂ plasma is used.

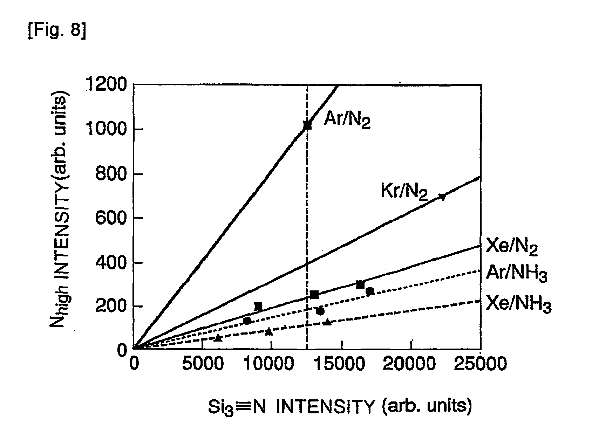

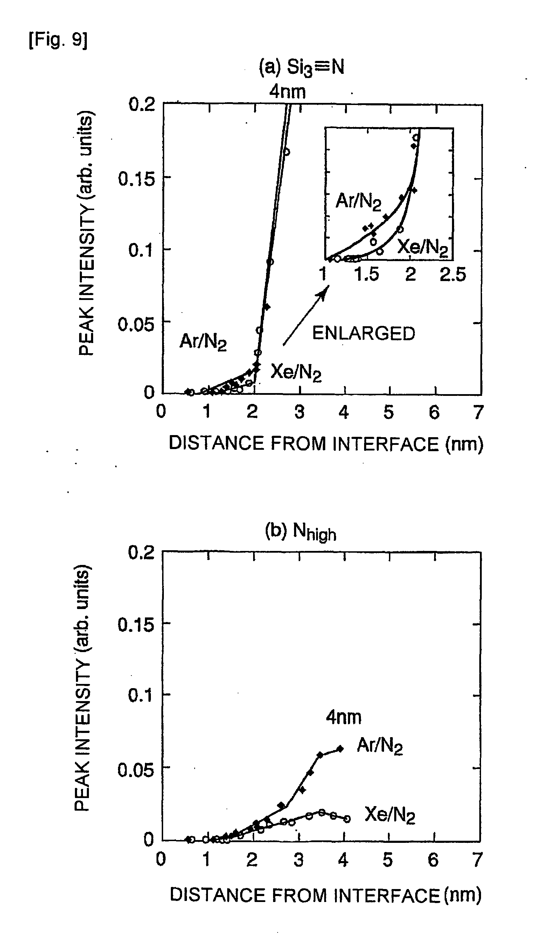

Fig. 8 is obtained by plotting the amount of Si₃≡N formation on the axis of abscissas and the amount of N_{high} formation on the axis of ordinates when using the respective gases and changing the nitriding time. It shows that when the gas such as NH₃/Ar, N₂/Xe, NH₃/Xe, or Kr/N₂ is used, the amount of N_{high} formation is reduced as compared with using Ar/N₂ while Si₃≡N necessary for preventing B diffusion is formed. As shown in Fig. 9, (a) and (b), this makes it possible to reduce the amount of Si₃≡N formation (no skirt tailing of Si₃≡N distribution) in the vicinity of the interface.

Further, it is possible to prevent the expansion of Si₃≡N distribution to the interface side due to 02 annealing and, further, to completely remove N_{high}. The minimum annealing condition is annealing in a vacuum or in an inert gas at 500 to 600°C.

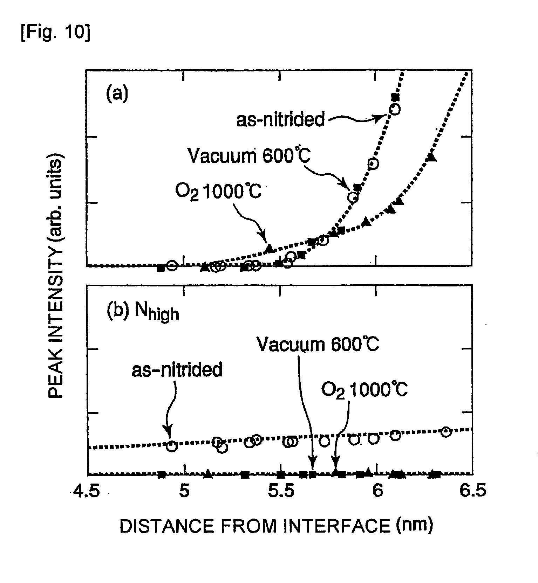

This is determined from the fact that N_{high} completely disappears at 500°C or more as shown in Fig. 4 and that there is no expansion at all of Si₃≡N distribution to the interface side in the case of vacuum annealing at 600°C or less as shown in Fig. 10.

Further, since the poly-Si CVD film forming temperature in the next step is generally about 500 to 600°C, the post-annealing step can be omitted by performing it by way of pre-annealing for the poly-Si film formation.

However, in order to use such an annealing condition, it is essential not to damage a gate insulating film. Therefore, it is necessary to use a plasma with an electron temperature of 1eV or less.

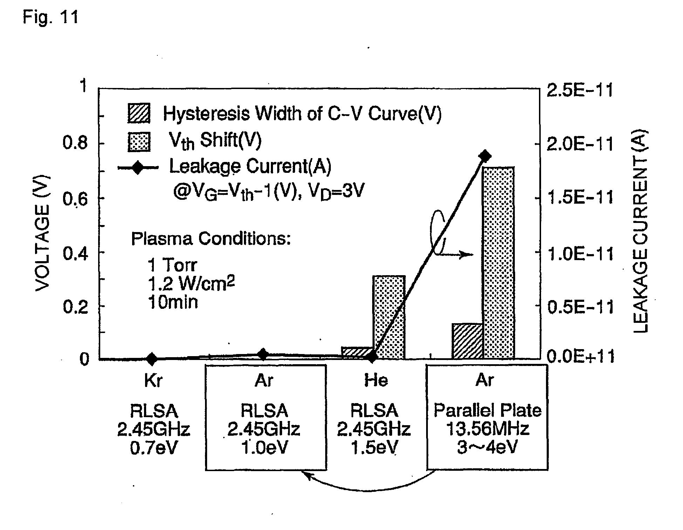

In the case of generating a plasma using an RLSA (radial line slot antenna), it is possible to generate a plasma with an extremely low electron temperature of 1 eV or less with Ar, 0.5eV or less with Xe, or 0.7eV or less with Kr. As shown in Fig. 11, damage is large in the case of a plasma generated by parallel flat plate electrodes, while, there is no damage in the case of the plasma generated by the RLSA. Consequently, a problem such as an increase in C-V curve hysteresis, threshold shift, or leakage current hardly occurs.

Therefore, by generating a plasma with a Xe/N₂, Kr/N₂, Ar/NH₃, Xe/NH₃, Kr/NH₃, Ar/N₂/H₂, Xe/N₂/H₂, or Kr/N₂/H₂ gas using an RLSA to carry out radical nitriding and performing post-annealing in a vacuum or in an inert gas at 500 to 600°C, a nitriding species N_{β} adapted to form N_{high} is reduced as compared with the case of using an Ar/N₂ gas. Thus, it is possible to suppress the formation of Si₃≡N at the interface. Further, since O₂ post-annealing is not required, it is also possible to prevent the expansion of Si₃≡N to the interface side and, further, to completely remove N_{high}.

A plasma is not limited to that generated by an RLSA, but a plasma generated by a method other than that may be used as long as the electron temperature is 1eV or less.

### Effect of the Invention

According to this invention, by reducing the generation efficiency, in a plasma, of a nitriding species adapted to form N_{high}, it is possible to reduce the amount of Si₃≡N formation in the vicinity of the interface. In this manner, the degradation of NBTI characteristics can be suppressed..

Further, since the amount of N_{high} formation is reduced, it is also possible to suppress generation of fixed charges formed after desorption of N_{high} by annealing. Thus, it is possible achieve an improvement of the insulating properties such as a reduction in leakage current and a reduction in dielectric breakdown lifetime.

In this manner, it is possible to reduce the thickness of a silicon oxide film, thereby achieving higher performance of an ultra-LSI.

### Brief Description of the Drawings

[Fig. 1] A diagram showing the XPS N1s core-level photoelectron spectra of (a) the surface of a silicon oxide film radical-nitrided by an Ar/N₂ plasma, (b) the surface of an SiN film formed by radical-nitriding a Si substrate using an Ar/N₂ plasma, (c) the surface of a silicon oxide film thermally nitrided by an NO gas, and (d) the surface of an Si₃N₄ film formed by thermal CVD.
[Fig. 2] A diagram showing changes, caused by O₂ post-annealing, of depth profiles of Si₃≡N and N_{high} obtained by an XPS depth analysis using HF etching on the surface of the silicon oxide film radical-nitrided by the Ar/N₂ plasma.

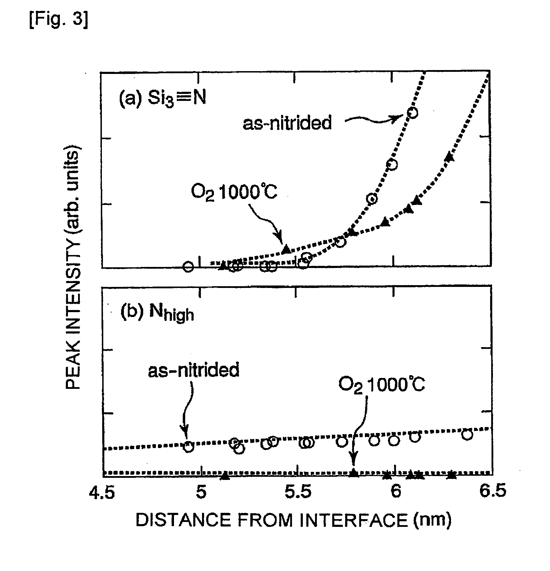

[Fig. 3] A diagram enlargedly showing the skirts of peaks of the depth profiles of Si₃≡N and N_{high} obtained by the XPS depth analysis, thereby showing the changes caused by the O₂ post-annealing.
[Fig. 4] A diagram showing a graph indicating the annealing temperature dependence of the amount of N_{high} formation.
[Fig. 5] A diagram showing the base oxide film thickness dependence of the depth profiles of (a) Si₃≡N and (b) N_{high} obtained by the XPS depth analysis using the HF etching on the surface of the silicon oxide film radical-nitrided by the Ar/N₂ plasma.
[Fig. 6] A reaction model diagram showing the state where, in radical nitriding of a silicon oxide film using an Ar/N₂ plasma, there exist a nitriding species adapted to form Si₃≡N and a nitriding species adapted to form N_{high} and, when the film thickness is reduced, the nitriding species adapted to form N_{high} reaches the vicinity of the interface earlier and forms Si₃≡N.
[Fig. 7] A diagram showing the XPS N1s core-level photoelectron spectra of the surfaces of silicon oxide films radical-nitrided by Ar/N₂, Ar/NH₃, Xe/N₂, Xe/NH₃, and Kr/N₂ plasmas, respectively.
[Fig. 8] A diagram quantitatively showing that N_{high} in Fig. 7 is reduced.
[Fig. 9] A diagram comparing depth profiles of (a) Si₃≡N and (b) N_{high} obtained by an XPS depth analysis using HF etching on the surfaces of the silicon oxide films radical-nitrided by the Ar/N₂ and Xe/N₂ plasmas, respectively.
[Fig. 10] A diagram enlargedly showing the skirts of peaks of the depth profiles of Si₃≡N and N_{high} obtained by the XPS depth analysis, thereby showing changes caused by vacuum annealing at 600°C.
[Fig. 11] A diagram showing that a plasma generated by parallel flat plates damages a gate insulating film, while a plasma with a low electron temperature generated by an RLSA does not damage a gate insulating film.
[Fig. 12] A diagram showing an apparatus for carrying out radical nitriding by a plasma generated using an RLSA in Embodiment 1.

### Best Mode for Carrying Out the Invention

### (Embodiment 1)

There are shown the process of forming a dielectric film according to Embodiment 1 of this invention and the process of manufacturing a semiconductor device using such a dielectric film.

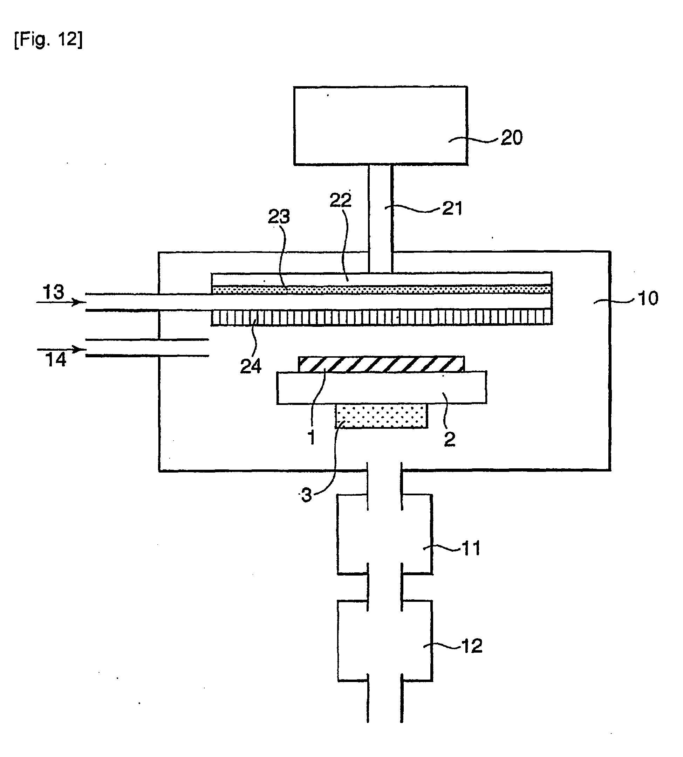

As shown in Fig. 12, a processing substrate 1 is placed on a sample stage 2 in a process chamber 10. The temperature of the substrate is set to 400°C by a heating mechanism 3. The process chamber 10 is evacuated by an exhaust pump 11 and a noble gas recovering apparatus 12 is connected thereto.

A microwave generated by a microwave generator 20 passes through a waveguide 21 so as to be introduced into an RLSA 22. A dielectric plate 23 is disposed under the RLSA 22 and, just under it, a process gas is introduced and a plasma with an electron temperature of 1eV or less is generated by the microwave. Radicals generated in the plasma diffuse toward the substrate 1 through a shower plate 24 so as to in-plane uniformly nitride the substrate 1. Even if the gas is introduced from a process gas introducing port 14 without using the shower plate 24, there is no influence on the N_{high} reducing effect. As the process gas, use is made of any one of combinations of Xe/N₂, Kr/N₂, Ar/NH₃, Xe/NH₃, Kr/NH₃, Ar/N₂/H₂, Xe/N₂/H₂, and Kr/N₂/H₂.

Heating of the substrate 1 is performed at 400°C or less. Post-annealing is not carried out. However, in a poly-Si CVD furnace in the next process, annealing is performed in a vacuum or in an inert gas at 500 to 600°C and, subsequently, poly-Si film formation is performed. This annealing at 500 to 600°C is a process necessary for completely removing N_{high}, but is performed by way of pre-annealing for the poly-Si film formation, thereby reducing the number of processes. If an electrode of other than poly-Si is used, annealing at 500 to 600°C is required separately.

### Industrial Applicability

According to this invention, by reducing the generation efficiency, in a plasma, of a nitriding species adapted to form N_{high,} it is possible to reduce the amount of Si₃=N formation in the vicinity of the interface. Thus, it is possible to suppress the degradation of NBTI characteristics. Further, since the amount of N_{high} formation is reduced, it is also possible to suppress generation of fixed charges formed after desorption of N_{high} by annealing, thereby achieving an improvement of the insulating properties such as a reduction in leakage current and a reduction in dielectric breakdown lifetime. In this manner, this invention can reduce the thickness of a silicon oxide film and thus is applicable to an ultra-LSI that can achieve higher performance.

## Claims

1. A dielectric film formed on a silicon surface, wherein:
an N concentration at a surface of the dielectric film is 3 at% or more,
an N concentration present at an interface between the silicon surface and the dielectric film is 0.1 at% or less, and
a film thickness is 2nm or less.

2. A semiconductor device comprising a silicon substrate, a dielectric film formed on a surface of the silicon substrate, and an electrode formed on the dielectric film, wherein:
an N concentration at a surface of the dielectric film is 3 at% or more,
an N concentration present at an interface between the silicon surface and the dielectric film is 0.1 at% or less, and
a film thickness is 2nm or less.

3. A method of forming a dielectric film, comprising the steps of:
forming a silicon oxide film on a surface of a silicon substrate, and
altering a surface of the silicon oxide film by exposing the surface to a nitriding species such as a nitriding radical species, a nitriding excited active species, or a nitriding ion species.

4. A method of forming a dielectric film according to claim 3, wherein:
the nitriding radical species is at least one radical selected from the group consisting of N radical, N⁺ ion radical, N₂ radical, N₂⁺ ion radical, NH radical, and NH⁺ ion radical.

5. A method of forming a dielectric film according to claim 3 or 4, wherein:
the nitriding radical is formed by a microwave plasma formed in a mixed gas of Ar and NH₃, a mixed gas of Xe and N₂, a mixed gas of Xe and NH₃, a mixed gas of Kr and N₂, a mixed gas of Kr and NH₃, a mixed gas of Ar, N₂, and H₂, a mixed gas of Xe, N₂, and H₂, and a mixed gas of Kr, N₂, and H₂.

6. A method of forming a dielectric film according to any one of claims 3 to 5, wherein:
the step of altering the surface of the silicon oxide film by exposing the surface to the nitriding species such as the nitriding radical species, the nitriding excited active species, or the nitriding ion species is not followed by post-annealing at 600°C or more.

7. A method of forming a dielectric film according to any of claims 3 to 6, wherein:
the step of altering the surface of the silicon oxide film by exposing the surface to the nitriding species such as the nitriding radical species, the nitriding excited active species, or the nitriding ion species is performed at a temperature of 600°C or less and followed by post-annealing in a vacuum or in an inert gas such as N₂, Ar, Xe, or Kr at 500 to 600°C.

8. A method of forming a dielectric film according to any of claims 3 to 7, wherein:
the step of altering the surface of the silicon oxide film by exposing the surface to the nitriding species such as the nitriding radical species, the nitriding excited active species, or the nitriding ion species is performed at a temperature of 600°C or less and post-annealing in a vacuum or in an inert gas such as N₂, Ar, Xe, or Kr at 500 to 600°C is performed by way of pre-annealing for poly-Si film formation in a next step so as to reduce one post-annealing step.

9. A method of manufacturing the semiconductor device, comprising the steps of:
forming a silicon oxide film on a surface of a silicon substrate,
altering a surface of the silicon oxide film by exposing the surface to a nitriding species such as a nitriding radical species, a nitriding excited active species, or a nitriding ion species, and
forming a gate electrode on the altered surface of the silicon oxide film.

10. A method of manufacturing the semiconductor device according to claim 9, wherein:
the nitriding radical species is at least one radical selected from the group consisting of N radical, N⁺ ion radical, N₂ radical, N₂⁺ ion radical, NH radical, and NH⁺ ion radical.

11. A method of manufacturing the semiconductor device according to claim 9 or 10, wherein:
the nitriding radical is formed by a microwave plasma formed in a mixed gas of Ar and NH₃, a mixed gas of Xe and N₂, a mixed gas of Xe and NH₃, a mixed gas of Kr and N₂, a mixed gas of Kr and NH₃, a mixed gas ofAr, N₂, and H₂, a mixed gas of Xe, N₂, and H₂, and a mixed gas of Kr, N₂, and H₂.

12. A method of manufacturing the semiconductor device according to any one of claims 9 to 11, wherein:
the step of altering the surface of the silicon oxide film by exposing the surface to the nitriding species such as the nitriding radical species, the nitriding excited active species, or the nitriding ion species is performed at a temperature of 600°C or less and is not followed by post-annealing at 600°C or more.

13. A method of manufacturing the semiconductor device according to any one of claims 9 to 12, wherein:
the step of altering the surface of the silicon oxide film by exposing the surface to the nitriding species such as the nitriding radical species, the nitriding excited active species, or the nitriding ion species is performed at a temperature of 600°C or less and followed by post-annealing in a vacuum or in an inert gas such as N₂, Ar, Xe, or Kr at 500 to 600°C.

14. A method of manufacturing the semiconductor device according to any one of claims 9 to 13, wherein:
the step of altering the surface of the silicon oxide film by exposing the surface to the nitriding species such as the nitriding radical species, the nitriding excited active species, or the nitriding ion species is performed at a temperature of 600°C or less and post-annealing in a vacuum or in an inert gas such as N₂, Ar, Xe, or Kr at 500 to 600°C is performed by way of pre-annealing for poly-Si film formation in a next step so as to reduce one post-annealing step.

15. A dielectric film according to claim 1, wherein:
a generation method of the plasma uses a microwave radiated from an RLSA (radial line slot antenna).

16. A semiconductor device according to claim 2, wherein:
a generation method of the plasma uses a microwave radiated from an RLSA.

17. A method of forming a dielectric film according to any one of claims 3 to 8, wherein:
a generation method of the plasma uses a microwave radiated from an RLSA.

18. A method of manufacturing the semiconductor device according to any one of claims 9 to 14, wherein:
a generation method of the plasma uses a microwave radiated from an RLSA.
